# EUROPÄISCHE PATENTANMELDUNG

(11) **EP 4 538 728 A1**
(43) Veröffentlichungstag der Anmeldung: **16.04.2025**
(21) Anmeldenummer: 23202585.8
(22) Anmeldetag: 10.10.2023
(51) Int. Cl.: G01R 31/382

(54) **VERFAHREN UND VORRICHTUNG ZUR BESTIMMUNG EINES KAPAZITÄTSVERLUSTS EINER BATTERIEZELLE**

(71) Anmelder: Siemens Aktiengesellschaft, 80333 München (DE)
(72) Erfinder: Arzberger, Arno, 96135 Stegaurach (DE); Fischer, Michael, 91320 Ebermannstadt (DE)
(74) Vertreter: Siemens Patent Attorneys

(57) **Zusammenfassung**

Es wird ein Verfahren zur Bestimmung eines Kapazitätsverlusts einer Batteriezelle (1a,1b) vorgeschlagen, wobei eine durch wenigstens einen Ladungswechsel induzierte Größenexpansion (40) der Batteriezelle (1) erfasst wird und der Kapazitätsverlust (41) durch ein für einen Zelltyp festgelegtes spezifisches Ausdehnungsprofil (42) bestimmt wird.

Weiterhin betrifft die Erfindung eine Vorrichtung zur Bestimmung eines Kapazitätsverlusts einer Batteriezelle (3), umfassend eine Messeinheit (20) und eine Recheneinheit (21), dadurch gekennzeichnet, dass die Messeinheit (20) dazu ausgebildet ist, eine Größenexpansion (33) der Batteriezelle bei einem Ladungswechsel zu erfassen, und die Recheneinheit (21) dazu ausgebildet ist, den von der Größenexpansion (33) abhängigen Kapazitätsverlusts (41) der Batteriezelle zu ermitteln, wobei die Recheneinheit (21) dazu ausgebildet ist, den Kapazitätsverlust (41) durch ein für einen Zelltyp festgelegtes spezifisches Ausdehnungsprofil (42) zu bestimmen.

## Beschreibung

Die Erfindung betrifft ein Verfahren zur Bestimmung eines Kapazitätsverlusts einer Batteriezelle gemäß dem Oberbegriff des Patentanspruches 1 sowie eine Vorrichtung gemäß dem Oberbegriff des Patentanspruches 5.

Eine Batteriezelle durchläuft am Ende ihrer Fertigung einen End-of-Line (EOL) Test, wobei die Batteriezellen nach festgelegten Qualitätsmerkmalen, beispielsweise ihrer Lebensdauer, unterschieden werden. Dieser Vorgang wird als Grading bezeichnet.

Die zyklische Lebensdauer einer Batteriezelle bemisst sich an der Anzahl möglicher Ladungswechsel, umfassend einen oder mehrere Ladezyklen und Entladezyklen, wobei die Batteriezelle bei jedem Ladungswechsel einer Zellalterung, beispielsweise durch Reaktionsnebenprodukte, unterliegt. Insbesondere ist eine Zellalterung durch einen Kapazitätsverlust gekennzeichnet.

Die Bestimmung des Kapazitätsverlusts einer Batteriezelle ist typischerweise Bestandteil des obengenannten End-of-Line Tests. Hierbei durchläuft die Batteriezelle einen oder mehrere Lade- und Entladezyklen und es wird die Differenz aus zugeführter und abgegebener Ladung erfasst. Die abgegebene Ladung ist hierbei kleiner als die zugeführte und die Größe dieser Ladungsdifferenz ist ein Maß für die Alterung der Batteriezelle.

Allerdings führen spezifische Selbstentladungseffekte der Batteriezelle zu einer erheblichen Ungenauigkeit bei der Erfassung des Kapazitätsverlusts.

Der vorliegenden Erfindung liegt die Aufgabe zugrunde, eine genauere Erfassung eines Kapazitätsverlusts von Batteriezellen bereitzustellen.

Die Aufgabe wird durch ein Verfahren mit den Merkmalen des unabhängigen Patentanspruches 1 und durch eine Vorrichtung mit den Merkmalen des unabhängigen Patentanspruches 5 gelöst. In den abhängigen Patentansprüchen sind vorteilhafte Ausgestaltungen und Weiterbildungen der Erfindung angegeben.

Das erfindungsgemäße Verfahren zur Bestimmung eines Kapazitätsverlusts einer Batteriezelle, erfolgt durch eine Erfassung einer bei wenigstens einem Ladungswechsel induzierten Größenexpansion der Batteriezelle, wobei der Kapazitätsverlust durch ein für einen Zelltyp festgelegtes spezifisches Ausdehnungsprofil bestimmt wird.

Der Kapazitätsverlust einer Batteriezelle, ist ein Maß für den Rückgang der speicherbaren elektrischen Ladung in einer Batteriezelle. Der Kapazitätsverlust einer Batteriezelle kann als Maß für die Alterung herangezogen werden.

Die Größenexpansion beim Ladungswechsel einer Batteriezelle kann durch die Anlagerung von Ladungsträgern und/oder chemischen Nebenprodukten in der Batteriezelle induziert werden. Hierbei expandiert die Batteriezelle in wenigstens eine von drei räumlichen Dimensionen beziehungsweise in eine der drei Raumrichtungen.

Beim Ladungswechsel einer Batteriezelle erfährt diese eine Ladung und Entladung, wobei die Reihenfolge aus Ladung und Entladung wechseln kann.

Das Ausdehnungsprofil einer Batteriezelle kann als Kennlinie den Zusammenhang zwischen der Größenexpansion und dem Kapazitätsverlust einer Batteriezelle beschreiben.

Durch die vorliegende Erfindung wird eine von der Selbstentladung sowie von Messfehlern bei der Ladungsmessung grundsätzlich unabhängige Erfassung des Kapazitätsverlusts erreicht. Das ist deshalb der Fall, da nicht die durch Selbstentladung fehlerbehaftete Differenz aus Ladung und Entladung, sondern die beim Ladungswechsel induzierte Größenexpansion erfasst wird.

Die erfindungsgemäße Vorrichtung zur Erfassung eines Kapazitätsverlusts einer Batteriezelle, umfasst eine Messeinheit und eine Recheneinheit. Die Messeinheit ist erfindungsgemäß dazu ausgebildet die Größenexpansion der Batteriezelle bei einem Ladungswechsel zu erfassen, und die Recheneinheit ist erfindungsgemäß dazu ausgebildet, den von der Größenexpansion abhängigen Kapazitätsverlusts der Batteriezelle zu ermitteln. Hierzu verwendet die Recheneinheit erfindungsgemäß ein für einen Zelltyp festgelegtes spezifisches Ausdehnungsprofil.

Durch die vorliegende Erfindung wird eine Vorrichtung mit vorteilhafter modularer Eigenschaft beschrieben. Das ist deshalb der Fall, da die Erfassung der Größenexpansion in der Messeinheit und die Berechnung des Kapazitätsverlusts in der Recheneinheit gekapselt und damit die beiden Einheiten, insbesondere zu Modernisierungszwecken, getrennt austauschbar sind.

Gemäß einer vorteilhaften Ausgestaltung kann die Größenexpansion in wenigstens einer Dimension des euklidischen Raums und/oder die abhängige Volumenänderung und/oder Druckänderung und/oder Kraftänderung erfasst werden.

Durch die Erfassung der Größenexpansion in wenigstens einer räumlichen Dimension oder der abhängigen Volumenänderung, kann vorteilhafterweise die Ausdehnung wesentlich genauer für eine räumliche Dimension oder für bis zu drei räumlichen Dimensionen erfasst werden.

Gemäß einer vorteilhaften Ausgestaltung der Erfindung kann die Selbstentladung der Batteriezelle, durch Subtraktion des erfassten Kapazitätsverlusts von einer Differenz aus einer zugeführten und einer entnommenen Ladung berechnet werden.

Die Selbstentladung einer Batteriezelle ist ein Maß für den Verlust von elektrischer Ladung über einen bestimmten Zeitraum, durch Vorgänge innerhalb der Batteriezelle, insbesondere wenn kein elektrischer Verbraucher betrieben wird.

Durch die genannte Berechnung der Selbstentladung wird vorteilhafterweise ein weiterer Qualitätsparameter für Batteriezellen, ergänzend zum Kapazitätsverlust, bereitgestellt.

In einer vorteilhaften Weiterbildung der Erfindung kann in Abhängigkeit einer Temperatur der Batteriezelle eine Temperaturkompensation mittels des spezifischen Ausdehnungsprofils erfolgen.

Dadurch ist es vorteilhafterweise möglich, die Erfassung des Kapazitätsverlust, bei einer sich ändernden Temperatur der Batteriezelle, zu ermöglichen.

In einer vorteilhaften Weiterbildung der Erfindung kann die Messeinheit als Dilatometer ausgebildet sein.

Dadurch kann vorteilhafterweise die Ausdehnung von komplexen Batteriezell-Geometrien erfassen.

In einer vorteilhaften Weiterbildung der Erfindung kann die Messeinheit als optische Messvorrichtung zur Interferometrie ausgebildet sein.

Dadurch kann vorteilhafterweise eine berührungsfreie Erfassung der Größenexpansion ermöglicht werden.

In einer vorteilhaften Weiterbildung der Erfindung kann die Messeinheit als induktive Messvorrichtung ausgebildet sein. Dadurch kann vorteilhafterweise mittels marktüblicher wartungsfreier induktiver Sensoren eine kostengünstige Erfassung ermöglicht werden.

In einer vorteilhaften Weiterbildung der Erfindung kann die Messeinheit als Dehnungsmesstreifen ausgebildet sein.

Dadurch kann vorteilhafterweise eine reine Widerstandmessung ermöglicht werden. Dies spart zusätzliche Auswerteeinheiten ein.

Gemäß einer vorteilhaften Ausgestaltung der Erfindung kann die Verwendung mehrerer Ausdehnungsprofile, abhängig von der Temperatur und dem Zelltyp, durch die Recheneinheit erfolgen.

Dadurch kann vorteilhafterweise auf eine sich ändernde Temperatur mit dem Ermitteln eines spezifischen Ausdehnungsprofils reagiert werden.

In einer vorteilhaften Weiterbildung der Erfindung kann die Messeinheit als eine kamerabasierte Vorrichtung ausgebildet sein.

Dadurch kann vorteilhafterweise mittels eines Tiefenbilds wenigstens einer 3D-Kamera die ein Laufzeitverfahren (Time-of-Flight, ToF) implementiert die Größenexpansion einer Batteriezelle dreidimensional ortsaufgelöst erfasst werden.

Gemäß einer vorteilhaften Ausgestaltung der Erfindung kann die Messeinheit als Kraftsensor und/oder Drucksensor ausgebildet sein.

Dadurch kann vorteilhafterweise eine Messung mit kostengünstigeren und marktverfügbaren Sensoren realisiert werden. Weitere Vorteile, Merkmale und Einzelheiten der Erfindung ergeben sich aus den im Folgenden beschriebenen Ausführungsbeispielen sowie anhand der Figuren. Dabei zeigen schematisiert:
- Figur 1: zwei Zelltypen von Batteriezellen als Ausführungsbeispiele und deren mögliche Größenexpansion im euklidischen Raum;
- Figur 2: ein Ausführungsbeispiel einer Vorrichtung in einer Komponentensichtweise; und
- Figur 3: ein Ausführungsbeispiel für ein Ausdehnungsprofil.

Gleichartige, gleichwertige oder gleichwirkende Elemente können in den Figuren mit denselben Bezugszeichen versehen sein.

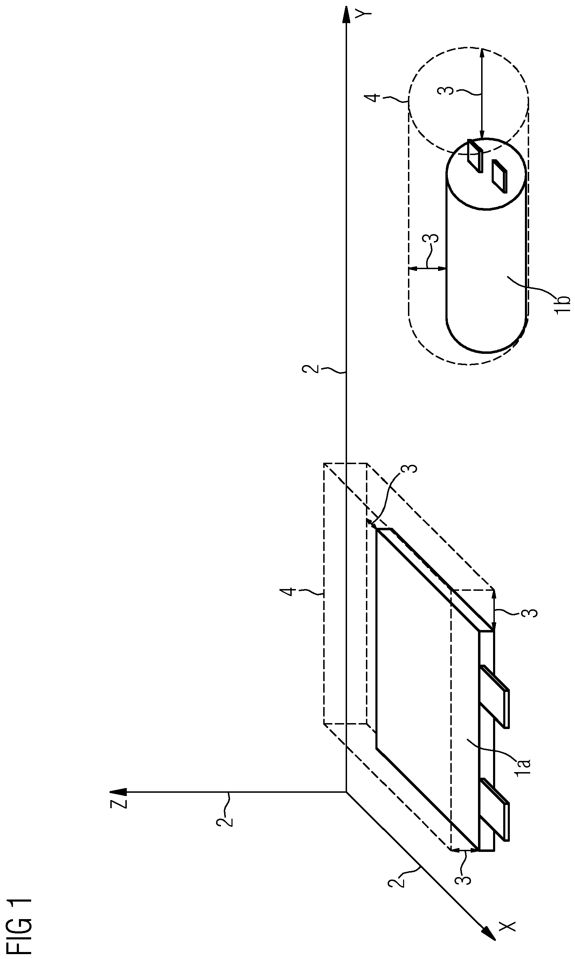

Die Figur 1 zeigt schematisch eine Pouch-Zelle 1a und eine zylindrische Batteriezelle 1b als zwei typische Zelltypen beziehungsweise Bauformen für Batteriezellen in den drei Dimensionen 2 des euklidischen Raums.

Gemäß der vorliegenden Ausgestaltung kommt es durch Ladung und Entladung der Batteriezellen 1a, 1b in Ausführungsbeispiel 1a und/oder 1b zu einer Anlagerung von Ladungsträgern und anderer chemischer Nebenprodukte innerhalb der jeweiligen Batteriezellen 1a, 1b. Diese Anlagerung induziert eine Größenexpansion 3 der Batteriezellen 1a, 1b in wenigstens einer Dimension 2 des euklidischen Raums.

Die Größenexpansion 3 einer Batteriezelle 1a oder 1b induziert eine spezifische Volumenänderung der jeweiligen Batteriezelle 1a, 1b. Diese wird als ein die jeweilige Batteriezelle 1a, 1b umgebenden Raum 4 in gestrichelte Linie dargestellt.

Mit anderen Worten kann die Größenexpansion 3 der jeweiligen Batteriezelle 1a, 1b, bezüglich Ihrer Proportionen in den drei räumlichen Dimensionen 2, batteriespezifisch sein. Der gestrichelte Raum 4 ist hierbei als eine konvexe Hülle ausgebildet, die mehrere Größenexpansionen 3 umfasst.

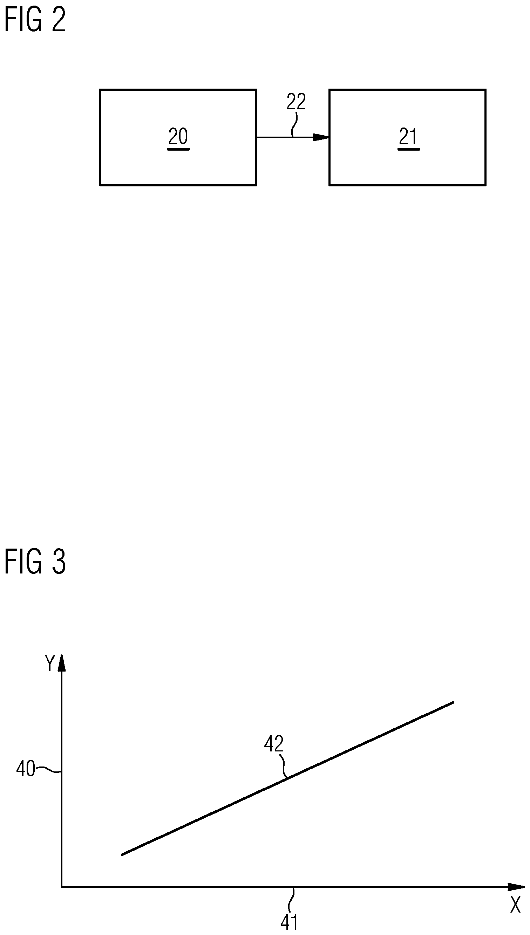

Die Figur 2 zeigt ein Ausführungsbeispiel der Vorrichtung zur Bestimmung eines Kapazitätsverlusts einer Batteriezelle. Diese umfasst eine Messeinheit 20, eine Recheneinheit 21 und einen Übertragungskanal 22.

Gemäß der vorliegenden Ausgestaltung erfasst die Messeinheit 20 eine Größenexpansion 3 und/oder eine von der Größenexpansion abhängige Volumenänderung und/oder eine Druckänderung und/oder eine Kraftänderung der Batteriezelle, insbesondere wenn die Zelle in ihrer Ausdehnung eingeschränkt wird. Die Recheneinheit 21 berechnet unter Verwendung eines Ausdehnungsprofils den Kapazitätsverlust aus der mittels der Messeinheit 20 erfassten Größenexpansion.

Der Übertragungskanal 22 ist als Pfeil dargestellt und verbindet die Messeinheit 20 und die Recheneinheit 21 in unidirektionaler Weise. Insbesondere umfasst der Kanal 22 die Übertragung von Messwerten von der Messeinheit 20 zur Recheneinheit 21.

Der Übertragungskanal 22 zwischen Messeinheit 20 und Recheneinheit 21 kann als elektrische, optische und/oder elektromagnetische Verbindung ausgebildet sein.

Die Figur 3 zeigt das Ausdehnungsprofil 42 in einem kartesischen Koordinatensystem gemäß einem Ausführungsbeispiel. Das Ausdehnungsprofil kann als eine Kennlinie eine Abhängigkeit zwischen der Größenexpansion 40 einer Batteriezelle auf der Ordinate und dem Kapazitätsverlust 41 auf der Abszisse herstellen, dabei kann der Kapazitätsverlust 41 die Dimension einer elektrischen Ladung aufweisen.

Die Größenexpansion 40 kann entweder als Dimension der Länge die Größenexpansion in einer einzigen räumlichen Dimension oder als eine Kombination aller drei räumlichen Dimensionen über die Volumenänderung als Volumeneinheit angegeben werden.

Ferner kann auch eine Druckänderung und/oder eine Kraftänderung der Batteriezelle, insbesondere wenn die Zelle in ihrer Ausdehnung eingeschränkt wird, mit der abhängigen Größenexpansion und/oder Volumenänderung korreliert werden und mit dem Kapazitätsverlust der Batteriezelle in einer Kennlinie dargestellt werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 1a: Batteriezelle als Pouch-Zelle
- 1b: Batteriezelle mit zylindrischer Form
- 2: Dimension im euklidischen Raum
- 3: Größenexpansion in einer räumlichen Dimension
- 4: Volumenänderung der Batteriezelle
- 20: Messeinheit
- 21: Recheneinheit
- 22: Übertragungskanal für Messwert der Größenexpansion
- 40: Größenexpansion in einer räumlichen Dimension als Längeneinheit
- 41: Kapazitätsverlust
- 42: Ausdehnungsprofil

## Patentansprüche

1. Verfahren zur Bestimmung eines Kapazitätsverlusts (41) einer Batteriezelle (1a, 1b), **gekennzeichnet dadurch, dass** eine durch wenigstens einen Ladungswechsel induzierte Größenexpansion (40) der Batteriezelle (1a, 1b) erfasst wird, wobei der Kapazitätsverlust (41) durch ein für einen Zelltyp festgelegtes spezifisches Ausdehnungsprofil (42) bestimmt wird.

2. Verfahren gemäß Anspruch 1, **dadurch gekennzeichnet, dass** die Größenexpansion (3) der Batteriezelle (1a, 1b) in wenigstens einer Dimension des euklidischen Raums (2) oder eine von der Größenexpansion (3) abhängige Volumenänderung und/oder Druckänderung und/oder Kraftänderung erfasst wird.

3. Verfahren gemäß einem der vorhergehenden Ansprüche, **dadurch gekennzeichnet, dass** eine Selbstentladung der Batteriezelle (1a, 1b) durch Subtraktion des erfassten Kapazitätsverlusts (41) von einer Differenz aus einer zugeführten und einer entnommenen Ladung berechnet wird.

4. Verfahren gemäß einem der vorhergehenden Ansprüche, **dadurch gekennzeichnet, dass** in Abhängigkeit einer Temperatur der Batteriezelle (1a, 1b) eine Temperaturkompensation mittels des spezifischen Ausdehnungsprofils (42) erfolgt.

5. Vorrichtung zur Bestimmung eines Kapazitätsverlusts (41) einer Batteriezelle (1a, 1b), umfassend eine Messeinheit (20) und eine Recheneinheit (21), **dadurch gekennzeichnet, dass** die Messeinheit (20) dazu ausgebildet ist, eine Größenexpansion (3) der Batteriezelle bei einem Ladungswechsel zu erfassen, und die Recheneinheit (21) dazu ausgebildet ist, den von der Größenexpansion (3) abhängigen Kapazitätsverlusts (41) der Batteriezelle zu ermitteln, wobei die Recheneinheit (21) dazu ausgebildet ist, den Kapazitätsverlust (41) durch ein für einen Zelltyp festgelegtes spezifisches Ausdehnungsprofil (42) zu bestimmen.

6. Vorrichtung gemäß Anspruch 5, **dadurch gekennzeichnet, dass** die Messeinheit (20) als Dilatometer ausgebildet ist.

7. Vorrichtung gemäß Anspruch 5 oder 6, **dadurch gekennzeichnet, dass** die Messeinheit (20) als optische Messvorrichtung zur Interferometrie ausgebildet ist.

8. Vorrichtung gemäß einem der Ansprüche 5 bis 7, **dadurch gekennzeichnet, dass** die Messeinheit (20) als induktive Messvorrichtung ausgebildet ist.

9. Vorrichtung gemäß einem der Ansprüche 5 bis 8, **dadurch gekennzeichnet, dass** die Messeinheit (20) als Dehnungsmesstreifen ausgebildet ist.

10. Vorrichtung gemäß einem der Ansprüche 5 bis 9, **dadurch gekennzeichnet, dass** die Recheneinheit (21) für eine Verwendung mehrerer Ausdehnungsprofile (42), abhängig von der Temperatur und dem Zelltyp, ausgebildet ist.

11. Vorrichtung gemäß einem der Ansprüche 5 bis 10, **dadurch gekennzeichnet, dass** die Messeinheit (20) als kamerabasierte Vorrichtung ausgebildet ist.

12. Vorrichtung gemäß einem der Ansprüche 5 bis 11, **dadurch gekennzeichnet, dass** die Messeinheit (20) als Kraftsensor und/oder Drucksensor ausgebildet ist.
